# FASCICULE DE BREVET EUROPEEN

(11) **EP 2 989 472 B1**
(45) Date de publication et mention de la délivrance du brevet: **30.08.2017**
(21) Numéro de dépôt: 14723015.5
(22) Date de dépôt: 23.04.2014
(51) Int. Cl.: G01P 21/00, G01D 18/00

(54) **DISPOSITIF D'ACQUISITION DIFFERENTIELLE DE COURANT ET PROCEDE DE COMMANDE D'UN TEL DISPOSITIF D'ACQUISITION**
DIFFERENZSTROM-MESSVORRICHTUNG UND VERFAHREN ZUM STEUERN EINE SOLCHE ERFASSUNGSVORRICHTUNG
DIFFERENTIAL CURRENT SENSING DEVICE AND METHOD FOR CONTROLLING SUCH A SENSING DEVICE

(30) Priorité: 26.04.2013 FR 1353825
(43) Date de publication de la demande: 02.03.2016
(73) Titulaire: Safran Electronics & Defense, 92100 Boulogne-Billancourt (FR)
(72) Inventeur: GENESTE, Nicolas, F-92100 Boulogne Billancourt (FR); VANOLI, Joël, F-92100 Boulogne Billancourt (FR); CHAMINADAS, Francis, F-92100 Boulogne Billancourt (FR)
(74) Mandataire: Lavialle, Bruno François Stéphane
(86) Numéro de dépôt international: PCT/EP2014/058283
(87) Numéro de publication internationale: WO 2014/173981

(56) Documents cités:
- EP-A1- 2 703 825
- US-A1- 2002 008 527
- US-A1- 2012 105 077
- US-A1- 2012 240 667

## Description

La présente invention concerne un dispositif d'acquisition différentielle et un procédé de commande d'un tel dispositif d'acquisition.

Il est connu des chaînes d'acquisition de charge qui sont raccordées aux bornes de capteurs comme par exemple des accéléromètres.

Une telle chaîne d'acquisition comprend généralement un amplificateur de charge relié en entrée au capteur et en sortie par exemple à un intégrateur relié à un élément de filtrage. Il est ainsi réalisé une acquisition différentielle de courant permettant de fournir un signal exploitable pour déterminer la grandeur détectée par le capteur.

Lorsque le capteur est monté pour fournir un signal quand survient un évènement particulier, comme une défaillance ou une vibration d'un appareil équipé du capteur, l'absence de signal en sortie de la chaîne d'acquisition peut résulter soit de l'absence de l'évènement en question, soit d'une défaillance (court-circuit, circuit ouvert...) de la chaîne d'acquisition et/ou du capteur.

Il est connu du document US-A-8 099 993 un procédé pour détecter la défaillance d'un accéléromètre auquel est reliée une chaîne d'acquisition de tension. Le procédé consiste à injecter un signal de tension à haute fréquence sur la borne positive de l'accéléromètre et à observer le signal présent en retour sur la borne négative du capteur pour le comparer au signal injecté et en déduire l'absence ou l'existence d'une défaillance du capteur.

Un tel procédé n'est cependant pas utilisable avec toutes les chaînes d'acquisition. En effet, l'injection d'un signal de tension n'est pas adaptée à une chaîne d'acquisition différentielle de courant du fait de l'existence d'une masse virtuelle.

Un but de l'invention est de proposer un moyen pour détecter une défaillance dans une chaîne d'acquisition différentielle.

A cet effet, on prévoit, selon l'invention, un dispositif d'acquisition différentielle de courant, selon la revendication 1.

Le composant émetteur est par exemple un capteur. L'injection d'un signal de charge (comme signal de test) en amont de l'amplificateur de charge et la comparaison du signal de charge avec le signal résultant obtenu en sortie de la chaîne d'acquisition permet de détecter des défaillances de la chaîne d'acquisition. Par exemple, des défaillances de la chaîne d'acquisition sont détectées au moyen de signaux de test injectés en mode différentiel en isolant le composant émetteur de la chaîne d'acquisition et les courts-circuits à la masse externes à la chaîne d'acquisition sont détectées au moyen des signaux de test injectés en mode commun.

L'invention a également pour objet un procédé de commande d'un tel dispositif d'acquisition. Le procédé comprend une phase d'acquisition nominale dans laquelle un signal en provenance du composant émetteur est amplifié de manière différentielle puis intégré pour fournir en sortie de la chaîne d'acquisition un signal de mesure. Le procédé comporte une phase de détection de panne qui comprend les étapes :
- d'injecter au moins un signal sinusoïdal de charge entre les bornes de raccordement au composant émetteur et l'amplificateur de charge,
- prélever un signal résultant en sortie de la chaîne d'acquisition,
- comparer le signal résultant au signal injecté pour déterminer un état de fonctionnement de la chaîne d'acquisition,

Selon l'invention, le procédé comprend l'étape de sélectionner entre l'injection du signal sinusoïdal de charge en mode différentiel et l'injection du signal sinusoïdal de charge en mode commun.

D'autres caractéristiques et avantages de l'invention ressortiront à la lecture de la description qui suit de modes de réalisation particuliers non limitatifs de l'invention.

Il sera fait référence aux dessins annexés, parmi lesquels :
- la figure 1 est une vue schématique d'un dispositif d'acquisition conforme à un premier mode de réalisation de l'invention,
- la figure 2 est une vue de détail de ce dispositif d'acquisition,
- la figure 3 est une vue analogue à la figure 1 du dispositif d'acquisition conforme à un deuxième mode de réalisation,
- la figure 4 est une vue analogue à la figure 1 d'une variante du deuxième mode de réalisation de l'invention.

L'invention est ici décrite en relation avec la détection de vibration au moyen d'au moins un accéléromètre. L'accéléromètre fournit un signal dont la charge électrique et représentative de l'accélération, signal qui est amplifié avant d'être intégré pour obtenir un signal de sortie représentatif de la vitesse. L'accéléromètre est par exemple fixé sur un appareil susceptible de vibrer, comme par exemple un moteur ou la structure d'un aéronef.

En référence aux figures, l'accéléromètre 1 est relié à un dispositif d'acquisition comprenant une chaîne d'acquisition généralement désignée en 10. L'invention s'applique à tout type de capteur et plus généralement à tout type de chaîne d'acquisition différentielle de charge ou de courant.

La chaîne d'acquisition 10 comprend un amplificateur de charge 20, ici monté en amplificateur différentiel intégrateur, relié en entrée à l'accéléromètre 1 et en sortie à un intégrateur 30. L'amplificateur de charge 20 et l'intégrateur 30 sont de constitution classique et ne seront pas détaillés ici. L'amplificateur de charge 20 a une impédance d'entrée proche de 0 Ohm.

L'intégrateur 30 a une sortie reliée à un filtre anti-repliement 40 lui-même relié à une unité de commande 50 via un convertisseur analogique numérique ici intégré à l'unité de commande 50. L'unité de commande 50 est agencée de manière connue en elle-même pour mener une phase d'acquisition nominale dans laquelle un signal en provenance de l'accéléromètre 1 est amplifié de manière différentielle puis intégré pour fournir en sortie du filtre anti-repliement un signal de mesure qui pourra être exploité soit par l'unité de commande 50 elle-même soit par un dispositif relié à l'unité de commande 50. L'unité de commande 50 peut être dédiée à une ou plusieurs chaînes d'acquisition ou faire partie d'un ensemble de commande plus important comme le FADEC dans le cas où le dispositif est embarqué sur un aéronef pour surveiller le fonctionnement d'un moteur de l'aéronef.

La chaîne d'acquisition 10 est ainsi agencée pour recevoir en entrée un signal représentatif de l'accélération à laquelle est soumis l'accéléromètre 1 et fournir en sortir un signal représentatif de la vitesse à laquelle est soumis l'accéléromètre 1. Bien entendu, dans le cadre de l'invention, il est possible d'omettre l'intégrateur 30 si l'on ne s'intéresse qu'à l'accélération, ou d'utiliser deux intégrateurs 30 successifs si l'on s'intéresse à la position. En utilisant deux intégrateurs 30 successifs, il est également possible de prélever le signal en sortie de l'amplificateur de charge 20 et de chacun des intégrateurs 30 de manière à obtenir trois signaux représentatifs respectivement de l'accélération, de la vitesse et de la position.

Plus précisément, la chaîne d'acquisition 1 comprend deux branches d'entrée s'étendant entre des bornes 5 de raccordement à l'accéléromètre 1 et des entrées de l'amplificateur de charge 20. Deux condensateurs 15 sont montés chacun sur une des branches d'entrée.

Conformément à l'invention, une unité 100 d'injection d'un signal de test est montée en amont de l'amplificateur de charge 20 et des condensateurs 15, et est reliée à l'unité de commande 50. L'unité de commande 50 est agencée pour commander l'injection d'un signal sinusoïdal de charge constituant le signal de test, détecter en sortie de la chaîne d'acquisition 10 un signal résultant et comparer le signal résultant au signal de test injecté.

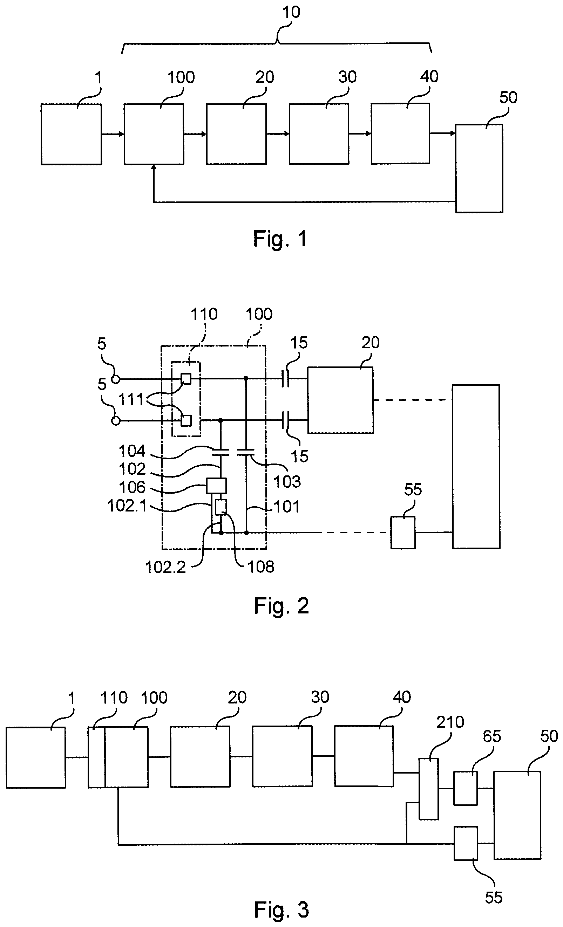

Plus précisément, dans le premier mode de réalisation de l'invention et en référence aux figures 1 et 2, l'unité d'injection 100 comprend un organe de multiplexage 110. L'organe de multiplexage 110 comporte des commutateurs 111 qui sont montés chacun sur une des branches d'entrée entre une des bornes 5 et un des condensateurs 15 et qui possèdent un état passant et un état bloqué. L'organe de multiplexage 110 est relié à l'unité de commande 50 pour sélectivement connecter les bornes 5 aux condensateurs 15, et donc à l'amplificateur de charge 20, et isoler les bornes 5 des condensateurs 15, et donc de l'amplificateur de charge 20.

L'unité d'injection 100 est reliée à une source de tension, ici un convertisseur numérique analogique 55 commandé par l'unité de commande 50, en sortie duquel sont raccordées deux lignes 101, 102 reliées chacune à une des branches d'entrée de la chaîne d'acquisition entre le commutateur 111 et le condensateur 15. Les lignes 101, 102 comportent chacune un condensateur 103, 104 respectivement. La ligne 102 est divisée en deux branches 102.1, 102.2 reliées à un commutateur 106 qui est monté en amont du condensateur 104 et qui possède un premier état de commutation et un deuxième état de commutation pour sélectivement raccorder au condensateur 104 soit la branche 102.1 soit la branche 102.2. Le commutateur 106 est relié à l'unité de commande 50 pour être commandé par celle-ci entre ses deux états de commutation. La branche 102.1 relie directement le commutateur 106 à la sortie du convertisseur numérique analogique 55 et la branche 102.2 relie le commutateur 106 à la sortie du convertisseur numérique analogique 55 via un inverseur 108. On comprend que lorsque le commutateur est dans son premier état de commutation, l'unité d'injection est agencée pour injecter le signal de charge en mode commun tandis que, lorsque le commutateur est dans son deuxième état de commutation, l'unité d'injection est agencée pour injecter le signal de charge en mode différentiel.

Le dispositif d'acquisition est commandé selon le procédé suivant, qui comprend une phase d'acquisition nominale et une phase de détection de panne.

Dans la phase d'acquisition nominale, un signal en provenance de l'accéléromètre 1 est amplifié de manière différentielle puis intégré pour fournir en sortie de la chaîne d'acquisition un signal de mesure.

Lors de phase de détection, le procédé comprend les étapes de :
- injecter le signal de test entre les bornes 5 et les condensateurs 15,
- prélever un signal résultant en sortie de la chaîne d'acquisition 10,
- comparer le signal résultant au signal de test injecté pour déterminer un état de fonctionnement de la chaîne d'acquisition 10.

Dans le procédé de l'invention se succèdent deux phases de détection. La première phase de détection est réalisée durant une phase d'initialisation précédant la phase d'acquisition nominale et la deuxième phase de détection est réalisée pendant la phase d'acquisition nominale. Le dispositif d'acquisition de l'invention incorpore donc des moyens de son diagnostic (en utilisation embarquée sur un aéronef, on parle de PBIT de l'anglais « power-on built-in test » pour la phase de détection effectuée à la mise en route de la chaîne d'acquisition et de CBIT de l'anglais « continuous built-in test » pour la phase de détection effectuée en continu.

Lors de la première phase de détection, l'unité de commande 50 pilote les commutateurs 111 dans leur état bloqué pour isoler la chaîne d'acquisition 10 de l'accéléromètre 1 et le commutateur 106 dans son deuxième état de commutation pour injecter le signal de test en mode différentiel.

Le signal de test est injecté lors d'une étape d'injection et le signal résultant est prélevé lors d'une étape d'écoute. Ces deux étapes sont menées simultanément. Une panne de la chaîne d'acquisition entraîne un niveau du signal résultant différent du niveau attendu.

Lors de la deuxième phase de détection, l'unité de commande 50 pilote les commutateurs 111 dans leur état passant pour raccorder la chaîne d'acquisition 1 à l'accéléromètre 1 et le commutateur 106 dans son premier état de commutation pour injecter de manière périodique le signal de test en mode commun. Le signal résultant est extrait d'un signal de sortie de la chaîne d'acquisition 10, le signal de sortie comportant le signal résultant et le signal de mesure.

Le signal de test est injecté lors d'une étape d'injection et le signal résultant est prélevé lors d'une étape d'écoute. Les deux signaux sont comparés. Une panne engendre une dissymétrie sur l'amplitude du signal résultant. Si les connections à l'accéléromètre 1 sont symétriques, c'est-à-dire s'il n'y a ni circuit ouvert ni court-circuit à la masse, il n'y aura pas de différence significative détectée lors de la soustraction du signal d'une branche d'entrée du signal de l'autre branche d'entrée. En cas de panne, un signal à la fréquence du signal de test va apparaître à la sortie de l'amplificateur de charge 20 révélant ainsi un dysfonctionnement de l'accéléromètre 1.

La fréquence du signal de test est choisie dans une plage de fréquences telle que :
- cette plage de fréquences soit située hors de la plage de fréquences des vibrations à détecter en mode nominal d'acquisition,
- ces fréquences soient inférieures à la fréquence de résonance de l'accéléromètre 1,
- ces fréquences soient inférieures à la fréquence du filtre anti-repliement 40.

De préférence, les signaux de test en mode commun sont injectés périodiquement de manière à éviter une fausse détection de panne en :
- distinguant le signal de test d'une harmonique du signal en provenance de l'accéléromètre 1,
- distinguant le signal de test d'une perturbation électromagnétique.

En variante encore, lors de la phase de détection se déroulant au cours de la phase d'acquisition nominale, le procédé comprend une étape d'injection d'un signal de test en mode commun et une étape d'injection de signal de test en mode différentiel, les étapes d'injection de signal se suivant avec une étape d'écoute pour le prélèvement des signaux résultant. L'unité de commande 50 comprend alors avantageusement un organe de filtrage pour extraire, d'un signal de sortie de la chaîne d'acquisition, le signal résultant de l'injection de chacun des signaux de test et un signal de mesure.

De préférence, la comparaison comprend une vérification d'une cohérence de phase entre le signal de test et le signal résultant. Ceci permet de s'assurer que le signal résultant est bien celui correspondant au signal de test et non un bruit. Avantageusement, on peut définir un seuil de variation d'amplitude en-dessous duquel la vérification de cohérence n'est pas nécessaire.

Le procédé selon l'invention est mis en oeuvre sans modification de l'accéléromètre 1 et avec des modifications limitées de la chaîne d'acquisition sur le plan du hardware par rapport aux chaînes d'acquisition existante.

Les éléments identiques ou analogues à ceux précédemment décrits porteront la même référence numérique dans la description qui suit du deuxième mode de réalisation.

Le procédé du deuxième mode de réalisation comprend deux phases de détection identiques à celles précédemment décrites.

En outre, dans le procédé selon le deuxième mode de réalisation de l'invention, la phase d'initialisation est utilisée pour réaliser une opération de compensation visant à éliminer les erreurs de gain des intégrations. On s'est en effet aperçu que les imprécisions de la chaîne d'acquisition sont principalement dues aux intégrations.

Le procédé de l'invention comprend donc une phase d'initialisation comportant des étapes de :
- mesurer des gains des intégrations (celle effectuée lors de l'amplification de charge comprise),
- déterminer au moins un coefficient de compensation en fonction des gains mesurés,
- appliquer le coefficient de compensation au signal de mesure.

L'étape de mesure des gains des intégrations est réalisée en injectant un signal de calibration en amont de l'amplificateur de charge 20 en ayant préalablement déconnecté l'accéléromètre 1 et la chaîne d'acquisition 10. Le signal de calibration est un signal sinusoïdal de charge comme les signaux de test évoqués plus haut. Sa fréquence est déterminée de telle manière que les intégrations aient un gain proche de 1. On compare ensuite le signal sinusoïdal de charge avec un signal résultant prélevé en sortie de la chaîne d'acquisition pour en déduire le gain d'intégration et le gain de compensation.

La chaîne d'acquisition 10 du deuxième mode de réalisation est globalement identique à celle du premier mode de réalisation.

Sur la figure 3, on peut ainsi voir successivement l'unité 100 d'injection du signal avec le multiplexeur 110 et le convertisseur numérique analogique 55, l'amplificateur de charge 20, l'intégrateur 30 et le filtre anti-repliement 40 relié à l'unité de commande 50.

Toutefois, au lieu d'être relié directement au convertisseur analogique numérique 65 de l'unité de commande 50 comme dans le premier mode de réalisation, le filtre anti-repliement 40 est relié à une première entrée d'un deuxième multiplexeur 210 qui a une sortie reliée au convertisseur analogique numérique 65 de l'unité de commande 50 et une deuxième entrée reliée à la sortie du convertisseur numérique analogique 55. Le multiplexeur 210 a un premier état de commutation dans lequel il raccorde le filtre anti-repliement 40 au convertisseur analogique numérique 65 de l'unité de commande 50 et un deuxième état de commutation dans lequel il raccorde le convertisseur numérique analogique 55 au convertisseur analogique numérique 65 de l'unité de commande 50.

Lors de l'étape d'injection du signal de calibration, l'unité de commande 50 pilote les commutateurs 111 dans leur état bloqué et le multiplexeur 210 dans son deuxième état de connexion puis commande l'injection du signal de calibration. L'unité de commande 50 pilote ensuite le multiplexeur 210 dans son premier état de commutation.

Ainsi, le convertisseur analogique numérique de l'unité de commande 50 va recevoir successivement le signal de calibration d'origine (via la deuxième entrée du multiplexeur 210) et le signal résultant correspondant au signal de calibration après passage dans la chaîne d'acquisition 10 (via la première entrée du multiplexeur 210). L'unité de commande 50 va calculer un ratio des deux signaux et divise ce ratio par le gain nominal théorique de la chaîne d'acquisition à la fréquence donnée pour obtenir un coefficient de compensation.

L'étape de compensation est réalisée en continu pendant la phase d'acquisition nominale. Chaque signal de mesure récupéré par l'unité de commande 50 est alors corrigé avec le coefficient de compensation préalablement déterminé.

La réalisation de l'étape de détection de gain pendant la phase d'initialisation permet de compenser les dispersions initiales ainsi que les erreurs liées au vieillissement des composants. On estime qu'ainsi, environ la moitié de l'erreur globale est compensée.

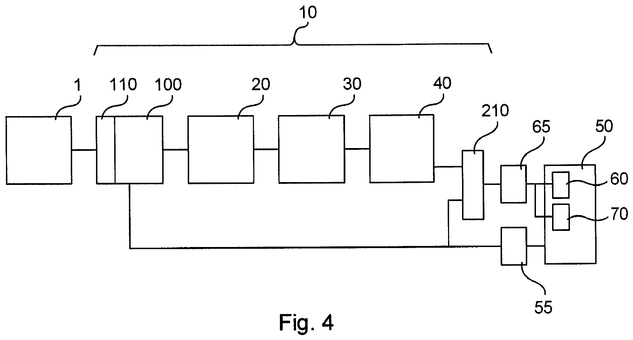

Dans la variante de la figure 4, l'étape de détection de gain est effectuée également en continu pendant la phase d'acquisition nominale de manière à pouvoir compenser également les erreurs causées par les variations de température. On estime qu'ainsi, environ les trois-quarts de l'erreur globale sont compensés.

Dans cette variante, il est prévue au sein de l'unité de commande 50 deux branches en sortie du convertisseur analogique numérique, à savoir une branche pourvue d'un filtre coupe-bande 60 permettant d'isoler le signal de mesure et une branche pourvue d'un filtre passe-bande 70 permettant d'isoler le signal résultant du signal de calibration.

L'exploitation du signal résultant du signal de calibration est identique à celle du deuxième mode de réalisation, ce qui permet de mettre à jour en continu le coefficient de compensation.

Bien entendu, l'invention n'est pas limitée aux modes de réalisation décrits mais englobe toute variante entrant dans le champ de l'invention telle que définie par les revendications.

En particulier, la chaîne d'acquisition peut avoir une structure différente de celle décrite et incorporer par exemple des moyens de filtrage supplémentaires, des moyens de protection contre la foudre, une self de mode commun en entrée de l'amplificateur de charge (dans ce cas, l'injection du signal de test est effectuée en amont de la self de mode commun)... L'organe de multiplexage 110 peut en outre être omis.

Les étapes de détection et d'écoute peuvent être simultanées ou non, continues ou périodiques.

En variante, la phase de compensation est réalisée hors de la phase d'acquisition nominale.

L'analyse du signal résultant peut être une comparaison directe, analogique ou numérique, du signal résultant avec le signal injecté. L'analyse peut également être une comparaison indirecte consistant à déterminer au moins une caractéristique du signal résultant et à la comparer avec une caractéristique attendue préalablement déterminée en fonction du signal injecté.

## Revendications

1. Dispositif d'acquisition différentielle de courant, comprenant une chaîne d'acquisition (10) comportant un amplificateur de charge (20) relié, en entrée, à des bornes de raccordement (5) à un composant émetteur (1) de signaux et, en sortie, à un intégrateur, (30) une unité d'injection d'un signal de charge (100) montée entre les bornes et l'amplificateur de charge et reliée à une unité de commande (50) reliée à une sortie de la chaîne d'acquisition, l'unité de commande étant agencée pour commander l'injection d'un signal de charge, détecter en sortie de la chaîne d'acquisition un signal résultant et comparer le signal résultant au signal injecté, **caractérisé en ce que** l'unité d'injection comprend une voie d'injection en mode commun et une voie d'injection en mode différentiel, et un commutateur (106) piloté par l'unité de commande pour sélectionner l'une ou l'autre des voies d'injection.

2. Dispositif selon la revendication 1, dans lequel l'unité d'injection est agencée pour injecter le signal de charge en mode commun.

3. Dispositif selon la revendication 1, dans lequel l'unité d'injection est agencée pour injecter le signal de charge en mode différentiel.

4. Dispositif selon la revendication 1, dans lequel l'unité d'injection comprend un organe de multiplexage (110) relié à l'unité de commande pour sélectivement connecter les bornes à l'amplificateur de charge et isoler les bornes de l'amplificateur de charge.

5. Dispositif selon la revendication 1, dans lequel l'unité d'injection comprend un convertisseur numérique analogique (55) ayant une entrée reliée à l'unité de commande et une sortie reliée en entrée de l'amplificateur de charge.

6. Dispositif selon la revendication 1, dans lequel l'unité de commande comprend un organe de filtrage (40) pour extraire d'un signal de sortie de la chaîne d'acquisition le signal résultant et un signal de mesure.

7. Procédé de commande d'un dispositif d'acquisition différentielle de courant selon l'une quelconque des revendications précédentes, comprenant une phase d'acquisition nominale dans laquelle un signal en provenance du composant émetteur est amplifié de manière différentielle puis intégré pour fournir en sortie de la chaîne d'acquisition un signal de mesure, le procédé comportant une phase de détection de panne qui comprend les étapes :
- d'injecter au moins un signal sinusoïdal de charge en amont de l'amplificateur de charge,
- prélever un signal résultant en sortie de la chaîne d'acquisition,
- comparer le signal résultant au signal injecté pour déterminer un état de fonctionnement de la chaîne d'acquisition,
**caractérisé en ce qu'**il comprend l'étape de sélectionner entre l'injection du signal sinusoïdal de charge en mode différentiel et l'injection du signal sinusoïdal de charge en mode commun.

8. Procédé selon la revendication 7, dans lequel la phase de détection est réalisée pendant la phase d'acquisition nominale et le signal résultant est extrait d'un signal de sortie de la chaîne d'acquisition, le signal de sortie comportant le signal résultant et le signal de mesure.

9. Procédé selon la revendication 8, dans lequel l'injection de signal est réalisée de manière périodique.

10. Procédé selon la revendication 7, dans lequel la phase de détection est réalisée hors de la phase d'acquisition nominale.

11. Procédé selon la revendication 7, comprenant une étape d'injection de signal de charge en mode commun et une étape d'injection de signal de charge en mode différentiel, les étapes d'injection de signal se suivant avec une étape de d'écoute pour le prélèvement des signaux résultant.

12. Procédé selon la revendication 7, dans lequel la comparaison comprend une vérification d'une cohérence de phase entre le signal injecté et le signal résultant.

13. Procédé selon la revendication 7, comprenant une phase de compensation comportant les étapes de :
- mesurer un gain d'intégration,
- déterminer au moins un coefficient de compensation en fonction des gains mesurés,
- appliquer le coefficient de compensation au signal de mesure.

14. Procédé selon la revendication 13, dans lequel la mesure du gain d'intégration est réalisée en injectant un signal sinusoïdal de charge en amont de l'amplification et de comparer le signal sinusoïdal de charge avec un signal résultant prélevé en sortie de la chaîne d'acquisition pour en déduire le gain d'intégration et le gain de compensation.

15. Procédé selon la revendication 14, dans lequel la phase de compensation est réalisée pendant la phase d'acquisition nominale et le signal résultant est extrait d'un signal de sortie de la chaîne d'acquisition, le signal de sortie comportant le signal résultant et le signal de mesure.

16. Procédé selon la revendication 14, dans lequel la phase de compensation est réalisée hors de la phase d'acquisition nominale.

## Patentansprüche

1. Vorrichtung zur Differenzstromerfassung, umfassend eine Erfassungskette (10), die einen Ladungsverstärker (20) enthält, der am Eingang mit Anschlussklemmen (5) zur Verbindung mit einer Signalsendekomponente (1) und am Ausgang mit einem Integrator (30) verbunden ist, eine Einheit zum Einkoppeln eines Ladungssignals (100), die zwischen den Klemmen und dem Ladungsverstärker geschaltet und mit einer Steuereinheit (50) verbunden ist, die mit einem Ausgang der Erfassungskette verbunden ist, wobei die Steuereinheit so ausgebildet ist, dass sie die Einkopplung eines Ladungssignals steuert, am Ausgang der Erfassungskette ein resultierendes Signal detektiert und das resultierende Signal mit dem eingekoppelten Signal vergleicht, **dadurch gekennzeichnet, dass** die Einkopplungseinheit einen Einkopplungskanal im Gleichtakt und einen Einkopplungskanal im Gegentakt umfasst, und einen Schalter (106), der von der Steuereinheit gesteuert wird, um den einen oder den anderen der Einkopplungskanäle auszuwählen.

2. Vorrichtung nach Anspruch 1, bei dem die Einkopplungseinheit so ausgebildet ist, dass sie das Ladungssignal im Gleichtakt einkoppelt.

3. Vorrichtung nach Anspruch 1, bei dem die Einkopplungseinheit so ausgebildet ist, dass sie das Ladungssignal im Gegentakt einkoppelt.

4. Vorrichtung nach Anspruch 1, bei dem die Einkopplungseinheit ein Multiplexelement (110) umfasst, das mit der Steuereinheit verbunden ist, um wahlweise die Klemmen mit dem Ladungsverstärker zu verbinden und die Klemmen von dem Ladungsverstärker zu trennen.

5. Vorrichtung nach Anspruch 1, bei dem die Einkopplungseinheit einen Digital-Analog-Umsetzer (55) umfasst, der einen Eingang hat, der mit der Steuereinheit verbunden ist, sowie einen Ausgang, der mit dem Eingang des Ladungsverstärkers verbunden ist.

6. Vorrichtung nach Anspruch 1, bei der die Steuereinheit ein Filterorgan (40) umfasst, um aus einem Ausgangssignal der Erfassungskette das resultierende Signal und ein Messsignal zu extrahieren.

7. Verfahren zum Steuern einer Vorrichtung zur Differenzstromerfassung nach einem der vorhergehenden Anspruche, umfassend eine nominale Erfassungsphase, in der ein Signal aus der Sendekomponente auf differentielle Weise verstärkt und dann integriert wird, um am Ausgang der Erfassungskette ein Messsignal zu liefern, wobei das Verfahren eine Störungserfassungsphase umfasst, die die Schritte umfasst:
- Einkoppeln mindestens eines sinusförmigen Ladungssignals stromaufwärts des Ladungsverstärkers,
- Abgreifen eines resultierenden Signals am Ausgang der Erfassungskette,
- Vergleichen des resultierenden Signals mit dem eingekoppelten Signal, um einen Funktionszustand der Erfassungskette zu bestimmen, **dadurch gekennzeichnet, dass** es den Schritt des Auswählens zwischen der Einkopplung des sinusförmigen Ladungssignals im Gegentakt und der Einkopplung des sinusförmigen Ladungssignals im Gleichtakt umfasst.

8. Verfahren nach Anspruch 7, bei dem die Detektionsphase während der nominalen Erfassungsphase erfolgt und das resultierende Signal aus einem Ausgangssignal der Erfassungskette extrahiert wird, wobei das Ausgangssignal das resultierende Signal und das Messsignal umfasst.

9. Verfahren nach Anspruch 8, bei dem die Signaleinkopplung periodisch erfolgt.

10. Verfahren nach Anspruch 7, bei dem die Detektionsphase außerhalb der nominalen Erfassungsphase erfolgt.

11. Verfahren nach Anspruch 7, umfassend einen Schritt einer Einkopplung eines Ladungssignals im Gleichtakt und einen Schritt einer Einkopplung eines Ladungssignals im Gegentakt, wobei die Signaleinkoppfungsschritte aufeinanderfolgen, mit einem Abhörschritt zum Abgreifen der resultierenden Signale.

12. Verfahren nach Anspruch 7, bei dem der Vergleich eine Verifizierung einer Phasenkohärenz zwischen dem eingekoppelten Signal und dem resultierenden Signal umfasst.

13. Verfahren nach Anspruch 7, umfassend eine Ifompensationsphase, umfassend die Schritte:
- Messen einer Integrationsverstärkung,
- Bestimmen mindestens eines Kompensationskoeffizienten in Abhängigkeit der gemessenen Verstärkungen,
- Anwenden des Kompensationskoeffizienten auf das Messsignal.

14. Verfahren nach Anspruch 13, bei dem die Messung der Integrationsverstärkung erfolgt, indem ein sinusförmiges Ladungssignal stromaufwärts der Verstärkung eingekoppeit wird und das sinusförmige Ladungssignal mit einem resultierenden Signal verglichen wird, das am Ausgang der Erfassungskette abgegriffen wird, um daraus die Integrationsverstärkung und die Kompensationsverstärkung herzuleiten.

15. Verfahren nach Anspruch 14, bei dem die Kompensationsphase während der nominalen Erfassungsphase erfolgt und das resultierende Signal aus einem Ausgangsignal der Erfassungskette extrahiert wird, wobei das Ausgangssignal das resultierende Signal und das Messsignal umfasst.

16. Verfahren nach Anspruch 14, bei dem die Kompensationsphase außerhalb der nominalen Erfassungsphase erfolgt.

## Claims

1. A device for the differential acquisition of current, comprising an acquisition circuit (10) comprising a charge amplifier (20) connected, at the input, to terminals for connection (5) to a signal emitting component (1), and at the output, to an integrator (30), **characterized in that** a unit for injecting a charge signal (100) is mounted between the terminals and the charge amplifier and is connected to a control unit (50) connected to an output of the acquisition circuit, the control unit is so arranged as to control the injection of a charge signal, to detect a resultant signal at the output of the acquisition circuit and to compare the resultant signal with the injected signal, **characterized in that** the injection unit comprises a channel of injection in common mode and a channel of injection in differential mode, and a switch (106) controlled by the control unit to select the one or the other of the injection channels.

2. A device according to claim 1, wherein the injection unit is so arranged as to inject the charge signal in common mode.

3. A device according to claim 1, wherein the injection unit is so arranged as to inject the signal charge in differential mode.

4. A device according to claim 1, wherein the injection unit comprises a multiplexing member (110) connected to the control unit for selectively connecting the terminals to the charge amplifier and to isolate the terminals of the charge amplifier.

5. A device according to claim 1, wherein the injection unit comprises a digital analog converter (55) having one input connected to the control unit and one output connected to the input of the charge amplifier.

6. A device according to claim 1, wherein the control unit comprises a filtering member (40) for extracting the resultant signal and a measurement signal from an output signal of the acquisition circuit.

7. A method for controlling a current differential acquisition device according to any one of the preceding claims, comprising a nominal acquisition phase wherein a signal from the emitting component is differentially amplified and then integrated for supplying a measurement signal at the output of the acquisition circuit, the method including a fault detection phase comprising the steps of:
- injecting at least one charge sine-wave signal upstream of the charge amplifier,
- taking off a resultant signal at the output of the acquisition circuit,
- comparing the resultant signal with the injected signal for determining a working condition of the acquisition circuit,
**characterized in that** it comprises the step of selecting between the injection of the charge sine-wave signal in differential mode and the injection of the charge sine-wave signal in common mode.

8. A method according to claim 8, wherein the step of detecting is executed during the nominal acquisition phase and the resultant signal is extracted from an output signal of the acquisition circuit, with the output signal comprising the resultant signal and the measurement signal.

9. A method according to claim 9, wherein the signal injection is periodically executed.

10. A method according to claim 8, wherein the step of detecting is executed outside the nominal acquisition phase.

11. A method according to claim 8, comprising a step of injecting a charge signal in common mode and a step of injecting a charge signal in differential mode, with the steps of injecting the signal following a step of listening for taking-off the resultant signals.

12. A method according to claim 8, wherein comparing comprises checking a phase coherence between the injected signal and the resultant signal.

13. A method according to claim 8, comprising a compensation phase comprising the steps of:
- measuring an integration gain,
- determining at least one compensation coefficient according to the measured gain,
- applying the compensation coefficient to the measurement signal.

14. A method according to claim 14, wherein measuring the integration gain is executed by injecting a charge sine-wave signal upstream of the amplifier and comparing the charge sine-wave signal with a resultant signal taken off at the output of the acquisition circuit in order to deduce therefrom the integration gain and the compensation gain.

15. A method according to claim 15, wherein the compensation phase is executed during the nominal acquisition phase and the resultant signal is extracted from an output signal of the acquisition circuit, with the output signal comprising the resultant signal and the measurement signal.

16. A method according to claim 15, wherein the compensation phase is executed outside the nominal acquisition phase.
